# EUROPÄISCHE PATENTSCHRIFT

(11) **EP 3 895 305 B1**
(45) Veröffentlichungstag und Bekanntmachung des Hinweises auf die Patenterteilung: **25.06.2025**
(21) Anmeldenummer: 19836463.0
(22) Anmeldetag: 03.12.2019
(51) Int. Cl.: H02P 6/26, H02P 29/024, H02P 8/02

(54) **SCHUTZSCHALTUNG EINES ELEKTROMOTORS MIT EINER EINPHASIGEN WICKLUNG, ELEKTRISCHE KREISELPUMPE UND ÖLNEBELABSCHEIDER MIT EINER DERARTIGEN SCHUTZSCHALTUNG**
PROTECTIVE CIRCUIT OF AN ELECTRIC MOTOR WITH A SINGLE-PHASE WINDING, ELECTRICAL CENTRIFUGAL PUMP, AND OIL MIST SEPARATOR WITH SUCH A PROTECTIVE CIRCUIT
CIRCUIT DE PROTECTION D'UN MOTEUR ÉLECTRIQUE COMPRENANT UN ENROULEMENT MONOPHASÉ, POMPE CENTRIFUGE ÉLECTRIQUE ET SÉPARATEUR DE BROUILLARD D'HUILE COMPRENANT UN TEL CIRCUIT DE PROTECTION

(30) Priorität: 12.12.2018 DE 102018221538
(43) Veröffentlichungstag der Anmeldung: 20.10.2021
(73) Patentinhaber: Bühler Motor GmbH, 90459 Nürnberg (DE)
(72) Erfinder: WEISS, Jens, 90762 Fürth (DE)
(86) Internationale Anmeldenummer: PCT/DE2019/200138
(87) Internationale Veröffentlichungsnummer: WO 2020/119869

(56) Entgegenhaltungen:
- EP-A1- 2 278 339
- WO-A1-2015/018691
- DE-A1- 2 633 047
- US-A- 4 584 506
- US-A1- 2008 272 722
- TOKYO OFFICE ET AL: "SANYO Electric Co.,Ltd. Semiconductor Bussiness Headquarters Two-Phase Unipolar Brushless Motor Driver Automatic Recovery Type Circuit in a Miniature Flat Package", 1 January 1997 (1997-01-01), XP055675420, Retrieved from the Internet <URL:https://datasheetspdf.com/pdf-file/391520/Sanyo/LB1863M/1> [retrieved on 20200310]
- ON SEMICONDUCTOR: "AND8230/D Application Hints for Transient Voltage Suppression Diode Circuits", 1 January 2016 (2016-01-01), XP055675433, Retrieved from the Internet <URL:https://www.onsemi.com/pub/Collateral/AND8230-D.PDF> [retrieved on 20200310]

## Beschreibung

Die Erfindung betrifft eine Schutzschaltung eines Elektromotors mit einer einphasigen Wicklung (3), bestehend aus zwei Teilspulen (5, 6) mit Mittenabgriff (7), wobei die beiden Wicklungsenden der Teilspulen (5, 6) über jeweils ein Schaltelement (8, 9) mit Masse (10) verbunden sind.

Eine Kommutierung eines gattungsgemäßen Elektromotors mit einphasiger Wicklung wird so realisiert, dass die beiden Schaltelemente abwechselnd geschaltet werden, synchron zur elektrischen Drehzahl des Motors. Durch das abwechselnde Schalten wird ein Drehfeld im Stator des Elektromotors erzeugt, welches einen Permanentmagnetrotor mitschleppt. Eine derartige Schaltung wird auch als M-Schaltung bezeichnet. Beim Umschalten der Motorwicklungen muss die in der jeweiligen Teilspule gespeicherte elektrische Energie abgebaut werden. Da bei der genannten Verschaltung keine Freilaufdioden einsetzbar sind, steigt die Spannung am Schaltelement bis auf dessen Durchbruchspannung (Avalanche-Durchbruch) an und der Strom fließt über dieses Schaltelement zur Masse weiter. Dies hat einen steilen Anstieg des Stroms zur Folge. Die Verlustleistung errechnet sich dabei aus der Zeit, in welcher der Puls anliegt, aus der Durchbruchspannung und dem Strom der dabei fließt. Da Avalanche-Durchbrüche sehr energiereich sind werden Bauteile dabei sehr stark thermisch belastet. Die Toleranzen für die thermische Belastbarkeit von Schaltelementen sind aus wirtschaftlichen Gründen sehr begrenzt. Wird eine höhere Motorleistung angestrebt muss mit der thermischen Zerstörung der Bauteile gerechnet werden.

US 2008/272722 A1 offenbart eine Antriebsschaltung für einen bürstenlosen Gleichstrommotor. Diese Schaltung umfasst eine Antriebseinheit und eine Schaltung zur Unterdrückung von Transientströmen mit einem ersten Hilfstransistor und einem zweiten Hilfstransistor. Der erste Hilfstransistor erhält eines der komplementären digitalen Steuersignale, das sich von dem Signal unterscheidet, das der erste Transistor erhält. Der zweite Hilfstransistor erhält das andere komplementäre digitale Steuersignal, das sich von dem Signal unterscheidet, das der zweite Transistor erhält.

US 4 584 506 A beschreibt einen Reluktanzmotor mit elektrisch geschalteten Statorwindungen bei dem die Energie, die nach dem Abschalten einer Phasenwicklung freigesetzt wird, in einem Kondensator gespeichert wird. Diese Energie wird dann bei der nächsten Erregung der Wicklung wiederverwendet, um ein schnelles Ansteigen und Abfallen des Stroms zu ermöglichen, ohne den Stromfluss aus der Hauptstromversorgung zu beeinträchtigen.

Aufgabe der Erfindung ist es daher bei einem gattungsgemäßen Elektromotor für eine thermische Entlastung der Schaltelemente, für eine verbesserte Laufruhe, eine verringerte Erwärmung der Leiterplatte, ein verbessertes EMV-Verhalten, ein robusteres Design der Gesamtschaltung, eine gezielte Leitung der Verluste und für einen zusätzlichen Schutz vor sonstigen Überspannungspulsen aus einem Versorgungsnetz zu sorgen.

Diese Aufgabe wird erfindungsgemäß durch die Merkmale der Ansprüche 1, 11 und 14 gelöst. Da Schaltelemente, z. B. Feldeffekttransistoren oder auch bipolare Transistoren keine hohen Spannungspulse vertragen, wobei der Energieeintrag pro Zeiteinheit eine entscheidende Rolle spielt, wird vorgeschlagen, dass ein Abschaltstrom einer Teilspule (5, 6) über ein elektrisches Leistungsbauteil abgeleitet wird, welches parallel zum Schaltelement (8, 9) geschaltet ist. Dabei wird die in der Teilspule (5 bzw. 6) gespeicherte Energie über den Widerstand des Leistungsbauteils in Wärmeenergie umgewandelt. Das Schaltelement (8, 9) wird dadurch deutlich geringer thermisch belastet. Auf diese Weise schützt das Leistungsbauteil das Schaltelement (8, 9) vor einer möglichen thermischen Beschädigung oder Zerstörung. Weiter ist vorgesehen, dass zwischen einem Wicklungsende einer Teilspule und der Masse ein RC-Dämpfungsglied (Snubber-Netzwerk), bestehend aus einem Snubber-Widerstand (17) und einem Snubber-Kondensator (18), geschaltet ist. Hierdurch können Schaltflanken sauber geschaltet, Verluste in den Transistoren reduziert und das EMV-Verhalten kann verbessert werden. Das Snubber-Netzwerk kann je nach Anforderung auch weitere Bauteile enthalten.

Weiterbildungen der Erfindung werden in den Unteransprüchen dargestellt. Ein wesentliches Merkmal der Erfindung besteht generell darin, dass der Abschaltstrom einer Teilspule (5, 6) gesteuert werden kann. Hierdurch sind Anpassungen an unterschiedliche Umgebungsbedingungen oder spezielle Anforderungen möglich.

Gemäß einer ersten Ausführungsform der Erfindung ist vorgesehen, dass das elektrische Leistungsbauteil eine Leistungs-Z-Diode (11, 12) ist, wobei jeder Teilspule (5, 6) eine Leistungs-Z-Diode (11 bzw. 12) zugeordnet ist. Diese Lösung erfüllt zumindest die Forderung nach dem thermischen Schutz des Schaltelements (8, 9).

Um zusätzlich die Eigenschaften der Schutzschaltung einfacher einstellen und optimieren zu können, wird gemäß einer zweiten Ausführungsform der Erfindung vorgeschlagen einen bipolaren Leistungstransistor (13, 14) als elektrisches Leistungsbauteil einzusetzen, wobei jeder Teilspule (5, 6) ein bipolarer Leistungstransistor (13 bzw. 14) zugeordnet ist.

Um eine feinfühligere Steuerung des abzuleitenden Stroms zu erreichen wird der Leistungstransistor (13) von einem bipolaren Steuertransistor (14) durchgeschaltet, dessen Emitter an der Basis des Leistungstransistors (13) angeschlossen ist.

In Weiterbildung der zweiten Ausführungsform ist vorgesehen, dass die Basis des Steuertransistors (14) mit einer in Sperrrichtung betriebenen Steuer-Z-Diode (15) verbunden ist. Hierdurch wird erreicht, dass zunächst die Durchbruchspannung der Steuer-Z-Diode (15) erreicht sein muss, damit ein Basisstrom im Steuertransistor (14) fließt, welcher dann schaltet und den Leistungstransistor (13) steuert.

Eine Zusätzliche Beschaltung des Steuertransistors (14) kann das EMV-Verhalten positiv beeinflussen.

Damit die Basis-Emitter-Spannung an den Transistoren nicht zu groß wird und somit ein schnelles Schalten gewährleistet werden kann, ist die Basis des Steuertransistors (14) über Schottky-Dioden einerseits mit dem Spulenende einer Teilspule und andererseits mit der Basis des Leistungstransistors (13) verbunden.

Zweckmäßigerweise ist vorgesehen, dass das Schaltelement (8, 9) und der bipolare Leistungstransistor (13) thermisch entkoppelt sind. Dies kann durch einen möglichst großen Abstand dieser Bauteile untereinander auf derselben Leiterplatte oder durch Anordnung auf unterschiedlichen Leiterplatten oder Tragelementen und/oder durch Ableitung der Verlustwärme über Wärmeleitelemente, Kühlkörper oder ähnliche Maßnahmen erreicht werden.

Schließlich wird die Erfindung durch eine Kreiselpumpe mit einer Schutzschaltung nach zumindest einem der vorangehenden Merkmale gelöst.

Die beschriebene Schutzschaltung kann z. B. in einem bürstenlosen Gleichstrommotor mit einer Statorwicklung und einem Permanentmagnetrotor eingesetzt werden. Der Stator weist hierbei Klauenpole auf, welche mit einer Zylinderspule mit Mittenabgriff bewickelt sind.

Es ist bekannt derartige bürstenlose Gleichstrommotoren für Kfz-Kühlwasserpumpen, insbesondere Zusatz-Kühlwasserpumpen einzusetzen. Hierfür eignet sich auch die erfindungsgemäße Schutzschaltung mit allen in den Ansprüchen beschriebenen Varianten.

Auch bei elektrischen Ölnebelabscheidern im Kraftfahrzeug sind Elektromotoren mit einer Schutzschaltung einsetzbar. Der Elektromotor weist auch dabei eine einphasige Wicklung (3), bestehend aus zwei Teilspulen (5, 6) mit Mittenabgriff (7) auf, wobei die beiden Wicklungsenden der Teilspulen (5, 6) über jeweils ein Schaltelement, z. B. einen Feldeffekttransistor (8, 9) oder einen bipolaren Transistor mit Masse (10) verbunden sind, wobei ein Abschaltstrom einer Teilspule (5, 6) über ein elektrisches Leistungsbauteil abgeleitet wird, welches parallel zum Schaltelement (8, 9) geschaltet ist. Auch die übrigen genannten Merkmale sind auf diese Anwendung applizierbar.

Ein Ausführungsbeispiel der Erfindung wird nachfolgend anhand der Zeichnung näher erläutert. Es zeigen:
Fig. 1 ein Prinzipschaltbild einer ersten Ausführungsform der Erfindung,
Fig. 2 eine Teilschaltung einer zweiten Ausführungsform der Erfindung,
Fig. 3 eine Variante der zweiten Ausführungsform und
Fig. 4 eine zweite Variante der zweiten Ausführungsform.

Hinweis: Bezugszeichen mit Index und entsprechende Bezugszeichen ohne Index bezeichnen namensgleiche Einzelheiten in den Zeichnungen und der Zeichnungsbeschreibung. Es handelt sich dabei um die Verwendung in einer anderen Ausführungsform, dem Stand der Technik und/oder die Einzelheit ist eine Variante. Die Ansprüche, die Beschreibungseinleitung, die Bezugszeichenliste und die Zusammenfassung enthalten der Einfachheit halber nur Bezugszeichen ohne Index.

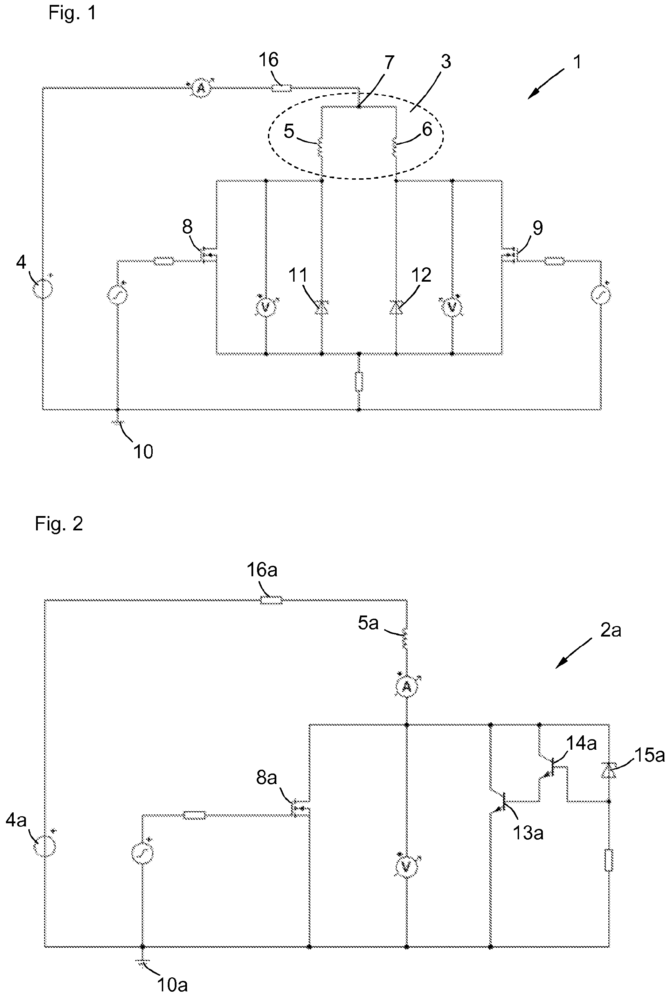

Fig. 1 zeigt ein Prinzipschaltbild 1 zur Erläuterung der grundsätzlichen Funktion. Dargestellt ist eine erste Teilspule 5, eine zweite Teilspule 6, ein Mittenabgriff 7, welcher an eine Spannungsquelle 4 (Versorgungsspannung) angeschlossen ist, während die beiden übrigen Spulenenden der Teilspulen 5, 6 mit jeweils einem Feldeffekttransistor 8 bzw. 9 verbunden sind. Die beiden Feldeffekttransistoren (MOSFET) schalten die Teilspulen 5, 6 abwechselnd zu, so dass ein Strom durch die Teilspulen 5 bzw. 6 fließt. Ein Ersatzwiderstand 16 stellt den DC-Widerstand der Wicklungen dar. Wird der erste Feldeffekttransistor 8 abgeschaltet, treibt die Induktivität der ersten Teilspule 5 den Strom weiter in die gleiche Richtung. In Folge steigt die Spannung am Feldeffekttransistor 8 an bis eine Durchbruchspannung einer parallel geschalteten Leistungs-Z-Diode 11 erreicht wird. Die Leistungs-Z-Diode 11 wird dabei leitfähig, weshalb der Strom nicht mehr über den Feldeffekttransistor 8, sondern über die Leistungs-Z-Diode 11 fließt. Somit wird die Energie der ersten Teilspule 5 nicht mehr am Feldeffekttransistor 8, sondern in der Leistungs-Z-Diode 11 in Wärme umgesetzt. Das gleiche gilt für die Beschaltung der zweiten Teilspule 6, deren Strom über den zweiten Feldeffekttransistor 9 bzw. die zweite Leistungs-Z-Diode abgeleitet wird. Ist der Strom aus der Motorwicklung 3 (Teilspule 5 oder 6) abgebaut, so sinkt die Spannung an den jeweiligen Leistungs-Z-Diode 11 bzw. 12 wieder und es fließt kein Strom mehr.

Fig. 2 zeigt eine Teilschaltung 2a , wobei nur eine von zwei Teilspulen 5a mit ihrer Beschaltung dargestellt ist. Hierbei wird die Energie der Teilspule 5a, die bei ihrer Abschaltung frei wird, nicht über eine Leistungs-Z-Diode, sondern über einen bipolaren Leistungstransistor 13a gleitet. Die Basis des bipolaren Leistungstransistors 13a ist mit dem Emitter eines Steuertransistors 14a verbunden. Die Basis des Steuertransistors 14a ist mit einer Steuer-Z-Diode 15a elektrisch verbunden. Nach Erreichen der Durchbruchspannung der Steuer-Z-Diode 15a fließt ein Steuerstrom über die Basis-Emitter-Strecker des Steuertransistors 14a, wodurch entsprechend der bipolare Leistungstransistor 13a durchschaltet und die Abschaltenergie der Teilspule aufnimmt, in Wärme umwandelt und diese an die Umgebung abgibt. Insgesamt verhält sich die Schaltung wie eine Z-Diode, jedoch sind die Verlustleistungsgrenze und Steuerbarkeit deutlich verbessert. Durch die Höhe des Basisstromes der Transistoren 14a, 13a und durch die Stromverstärkung der Transistoren 14a, 13a kann die Schaltung so angepasst werden, dass die Steilheit der Stromflanke eingestellt werden kann. Weiter ist ein Ersatzwiderstand 16a für den Widerstand der Teilspule 5a dargestellt.

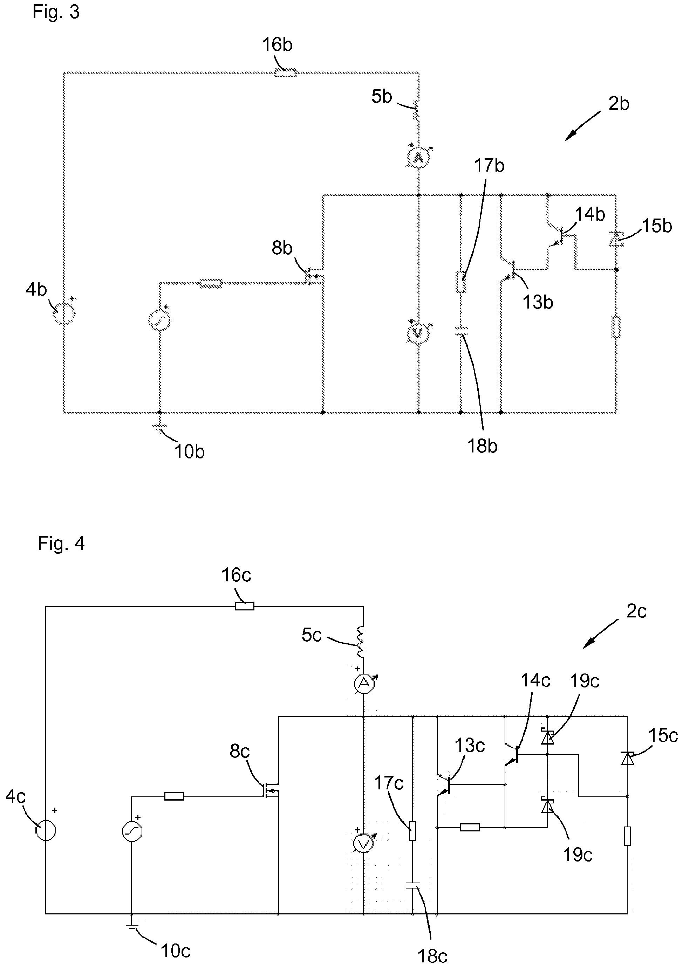

Fig. 3. Zeigt eine Variante der zweiten Ausführungsform gemäß Fig. 2 mit zusätzlichen Beschaltungselementen. Gezeigt ist eine Teilspule 5b, ein bipolarer Leistungstransistor 13b, ein Steuertransistor 14b eine Steuer-Z-Diode 15b, ein Ersatzwiderstand 16b für die Teilspule 5b und ein Feldeffekttransistor 8b zur Schaltung der Teilspule 5b. Zusätzlich sind ein Snubber-Widerstand 17b und ein Snubber-Kondensator 18b dargestellt, welche ein Snubber-Netzwerk bilden. Dieses bewirkt ein sauberes Schalten der Schaltflanke und hat damit einen positiven Einfluss auf die Verluste in den Transistoren und das EMV-Verhalten.

Fig. 4. zeigt eine zweite Variante der zweiten Ausführungsform der Erfindung. Hierbei wird die Energie der Teilspule 5c, die bei ihrer Abschaltung frei wird, ebenfalls über einen bipolaren Leistungstransistor 13c gleitet. Die Basis des bipolaren Leistungstransistors 13c ist mit dem Emitter eines Steuertransistors 14c verbunden. Die Basis des Steuertransistors 14c ist mit einer Steuer-Z-Diode 15c elektrisch verbunden. Nach Erreichen der Durchbruchspannung der Steuer-Z-Diode 15c fließt ein Steuerstrom über die Basis-Emitter-Strecker des Steuertransistors 14c, wodurch entsprechend der bipolare Leistungstransistor 13c durchschaltet und die Abschaltenergie der Teilspule 5c aufnimmt, in Wärme umwandelt und diese an die Umgebung abgibt. Insgesamt verhält sich die Schaltung wie eine Z-Diode, jedoch sind die Verlustleistungsgrenze und Steuerbarkeit deutlich verbessert. Durch die Höhe des Basisstromes der Transistoren 14c, 13c und durch die Stromverstärkung der Transistoren 14c, 13c kann die Schaltung so angepasst werden, dass die Steilheit der Stromflanke eingestellt werden kann. Weiter ist ein Ersatzwiderstand 16c für den Widerstand der Teilspule 5c dargestellt. Zusätzlich sind ein Snubber-Widerstand 17c und ein Snubber-Kondensator 18b dargestellt, welche ein Snubber-Netzwerk bilden. Dieses bewirkt ein sauberes Schalten der Schaltflanke und hat damit einen positiven Einfluss auf die Verluste in den Transistoren und das EMV-Verhalten. Weiter sind Schottky-Dioden 19c dargestellt, welche dafür sorgen, dass die Basis-Emitterspannung an den Transistoren nicht zu groß wird und somit ein schnelles Schalten gewährleistet werden kann. Hierzu ist die Basis des Steuertransistors (14c) über die Schottky-Dioden (19c) einerseits mit dem Spulenende einer Teilspule (5c) und andererseits mit der Basis des Leistungstransistors (13c) verbunden.

Es sind weitere Varianten denkbar, die hier jedoch nicht weiter beschrieben werden. Weiter muss nicht jede Teilspule eine eigene Beschaltung aufweisen, vielmehr lässt sich ein einziger Schaltungsblock für beide Teilspulen einsetzen.

### Bezugszeichenliste

- 1: Prinzipschaltbild
- 2: Teilschaltung
- 3: Wicklung
- 4: Spannungsquelle
- 5: erste Teilspule
- 6: zweite Teilspule
- 7: Mittenabgriff
- 8: erstes Schaltelement
- 9: zweites Schaltelement
- 10: Masse
- 11: erste Leistungs-Z-Diode
- 12: zweite Leistungs-Z-Diode
- 13: bipolarer Leistungstransistor
- 14: Steuertransistor
- 15: Steuer-Z-Diode
- 16: Ersatzwiderstand
- 17: Snubber-Widerstand
- 18: Snubber-Kondensator
- 19: Schottky-Diode

## Patentansprüche

1. Schutzschaltung eines Elektromotors mit einer einphasigen Wicklung (3), bestehend aus zwei Teilspulen (5, 6) mit Mittenabgriff (7), wobei die beiden Wicklungsenden der Teilspulen (5, 6) über jeweils einen Feldeffekttransistor (8, 9) mit Masse (10) verbunden sind, wobei ein Abschaltstrom einer Teilspule (5, 6) über ein elektrisches Leistungsbauteil abgeleitet wird, welches parallel zum Feldeffekttransistor (8, 9) geschaltet ist, wobei zwischen einem Wicklungsende einer Teilspule (5, 6) und der Masse (10) ein RC-Dämpfungsglied, genannt Snubber-Netzwerk, geschaltet ist.

2. Schutzschaltung nach Anspruch 1, **dadurch gekennzeichnet, dass** der Abschaltstrom einer Teilspule (5, 6) gesteuert werden kann.

3. Schutzschaltung nach Anspruch 1 oder 2, **dadurch gekennzeichnet, dass** das elektrische Leistungsbauteil eine Leistungs-Z-Diode (11, 12) ist, wobei jeder Teilspule (5, 6) eine Leistungs-Z-Diode (11 bzw. 12) zugeordnet ist.

4. Schutzschaltung nach Anspruch 1 oder 2, **dadurch gekennzeichnet, dass** das elektrische Leistungsbauteil ein bipolarer Leistungstransistor (13, 14) ist, wobei jeder Teilspule (5, 6) ein bipolarer Leistungstransistor (13 bzw. 14) zugeordnet ist.

5. Schutzschaltung nach Anspruch 4, **dadurch gekennzeichnet, dass** der bipolare Leistungstransistor (13) von einem Steuertransistor (14) durchschaltbar ist, dessen Emitter an der Basis des Leistungstransistors (13) angeschlossen ist.

6. Schutzschaltung nach Anspruch 5 **dadurch gekennzeichnet, dass** die Basis des Steuertransistors (14) mit einer in Sperrrichtung betriebenen Steuer-Z-Diode (15) verbunden ist.

7. Schutzschaltung nach Anspruch 6, **dadurch gekennzeichnet, dass** eine zusätzliche Beschaltung umfasst ist.

8. Schutzschaltung nach Anspruch 7, **dadurch gekennzeichnet, dass** die Basis des Steuertransistors (14) über Schottky-Dioden einerseits mit dem Spulenende einer Teilspule (5, 6) und andererseits mit der Basis des Leistungstransistors (13) verbunden ist.

9. Schutzschaltung nach zumindest einem der vorangehenden Ansprüche,
**dadurch gekennzeichnet, dass** der Feldeffekttransistor (8, 9) und der bipolare Leistungstransistor (13) thermisch entkoppelt sind.

10. Elektrische Kreiselpumpe mit einer Schutzschaltung eines Elektromotors nach einem der vorherigen Ansprüche.

11. Elektrische Kreiselpumpe nach Anspruch 10, **dadurch gekennzeichnet, dass** der Elektromotor ein bürstenloser Gleichstrommotor mit einer Statorwicklung ist.

12. Elektrische Kreiselpumpe nach Anspruch 10 oder 11, **dadurch gekennzeichnet, dass** die Kreiselpumpe eine Kfz-Kühlwasserpumpe ist, insbesondere eine Zusatz-Kühlwasserpumpe.

13. Elektrischer Ölnebelabscheider mit einer Schutzschaltung eines Elektromotors nach einem der Ansprüche 1 bis 9.

## Claims

1. Protection circuit of an electric motor having a single-phase winding (3), consisting of two coil sections (5, 6) having a centre tap (7), wherein the two winding ends of the coil sections (5, 6) are connected to earth (10) by means of one field-effect transistor (8, 9) each, wherein a turn-off current of a coil section (5, 6) is discharged via an electrical power component wired in parallel with the field-effect transistor (8, 9), wherein an RC attenuation member, referred to as a snubber network, is wired between a winding end of one coil section (5, 6) and earth (10).

2. Protection circuit according to claim 1, **characterised in that** the turn-off current of a coil section (5, 6) can be controlled.

3. Protection circuit according to claim 1 or claim 2, **characterised in that** the electrical power component is a power Zener (11, 12), each coil section (5, 6) being assigned one power Zener (11 or 12).

4. Protection circuit according to claim 1 or claim 2, **characterised in that** the electrical power component is a bipolar power transistor (13, 14), each coil section (5, 6) being assigned one bipolar power transistor (13 or 14).

5. Protection circuit according to claim 4, **characterised in that** the bipolar power transistor (13) can be driven by a control transistor (14), the emitter of which is connected to the base of the power transistor (13).

6. Protection circuit according to claim 5, **characterised in that** the base of the control transistor (14) is connected to a control Zener (15) operated in the reverse direction.

7. Protection circuit according to claim 6, **characterised in that** an additional RC circuit is included.

8. Protection circuit according to claim 7, **characterised in that** the base of the control transistor (14) is connected both to the coil end of a coil section (5, 6) by means of Schottky diodes and also to the base of the power transistor (13).

9. Protection circuit according to at least one of the preceding claims, **characterised in that** the field-effect transistor (8, 9) and the bipolar power transistor (13) are thermally decoupled.

10. Electric centrifugal pump comprising a protection circuit of an electric motor according to any of the preceding claims.

11. Electric centrifugal pump according to claim 10, **characterised in that** the electric motor is a brushless DC motor having a stator winding.

12. Electric centrifugal pump according to claim 10 or claim 11, **characterised in that** the centrifugal pump is a motor vehicle cooling-water pump, in particular an auxiliary cooling-water pump.

13. Electric oil mist separator comprising a protection circuit of an electric motor according to any of claims 1 to 9.

## Revendications

1. Circuit de protection d'un moteur électrique à enroulement monophasé (3),
composé de deux bobines partielles (5, 6) avec prise centrale (7), les deux extrémités d'enroulement des bobines partielles (5, 6) étant reliées à la masse (10) par l'intermédiaire d'un transistor à effet de champ (8, 9), un courant de coupure d'une bobine partielle (5, 6) étant dérivé par l'intermédiaire d'un composant électrique de puissance qui est monté en parallèle avec le transistor à effet de champ (8, 9), un dispositif d'atténuation RC, dénommé réseau snubber, étant monté entre une extrémité d'enroulement d'une bobine partielle (5, 6) et la masse (10).

2. Circuit de protection selon la revendication 1, **caractérisé en ce que** le courant de coupure d'une bobine partielle (5, 6) peut être réglé.

3. Circuit de protection selon la revendication 1 ou 2, **caractérisé en ce que**
le composant électrique de puissance est une diode Z de puissance (11, 12), chaque bobine partielle (5, 6) étant associée à une diode Z de puissance (11 ou 12).

4. Circuit de protection selon la revendication 1 ou 2, **caractérisé en ce que**
le composant électrique de puissance est un transistor de puissance bipolaire (13, 14), chaque bobine partielle (5, 6) étant associée à un transistor de puissance bipolaire (13 ou 14).

5. Circuit de protection selon la revendication 4, **caractérisé en ce que** le
transistor de puissance bipolaire (13) peut être commuté avec un transistor de commande (14) dont l'émetteur est raccordé à la base du transistor de puissance (13).

6. Circuit de protection selon la revendication 5, **caractérisé en ce que** la base du transistor de commande (14) est reliée à une diode Z de commande (15) fonctionnant dans le sens inverse.

7. Circuit de protection selon la revendication 6, **caractérisé en ce qu'**il comprend un câblage supplémentaire.

8. Circuit de protection selon la revendication 7, **caractérisé en ce que** la base du transistor de commande (14) est reliée par des diodes Schottky d'une part à l'extrémité d'une bobine partielle (5, 6) et d'autre part à la base du transistor de puissance (13).

9. Circuit de protection selon au moins l'une des revendications précédentes, **caractérisé en ce que** le transistor à effet de champ (8, 9) et le transistor de puissance bipolaire (13) sont découplés thermiquement.

10. Pompe centrifuge électrique avec un circuit de protection d'un moteur électrique selon l'une des revendications précédentes.

11. Pompe centrifuge électrique selon la revendication 10, **caractérisée en ce que** le moteur électrique est un moteur à courant continu sans balais avec un enroulement statorique.

12. Pompe centrifuge électrique selon la revendication 10 ou 11, **caractérisée en ce que** la pompe centrifuge est une pompe à eau de refroidissement pour véhicule automobile, en particulier une pompe à eau de refroidissement auxiliaire.

13. Séparateur de brouillard d'huile électrique avec un circuit de protection d'un moteur électrique selon l'une des revendications 1 à 9.
